# EUROPEAN PATENT SPECIFICATION

(11) **EP 2 839 300 B1**
(45) Date of publication and mention of the grant of the patent: **30.03.2016**
(21) Application number: 12714026.7
(22) Date of filing: 17.04.2012
(51) Int. Cl.: G01R 31/00

(54) **TRAIN TEST PLATFORM**
ZUGTESTPLATTFORM
PLATEFORME DE TEST DE TRAIN

(43) Date of publication of application: 25.02.2015
(73) Proprietor: Bombardier Transportation GmbH, 10785 Berlin (DE); Safran Engineering Services S.A.S., 31700 Blagnac (FR)
(72) Inventor: BOURGOIN, Frederick, 10115 Berlin (DE); CHATAIN, David, F-78180 Montigny-le-Bretonneux (FR); BERGER, Xavier, F-78180 Montigny-le-Bretonneux (FR); ECKEMARK, Andreas, S-72215 Västerås (SE); CORDELLE, Loic, Saint Bruno de Montarville, Québec J3V 6A2 (CA); GÜNTHER, Detlev, 16515 Oranienburg (DE); KIRCHHOF, Robert, 51503 Rösrath (DE); TORRADO, Gervasio, F-91470 Limours (FR); GIERING, Torsten, 14163 Berlin (DE)
(74) Representative: Patentanwälte Bressel und Partner mbB
(86) International application number: PCT/EP2012/057022
(87) International publication number: WO 2013/156062

(56) References cited:
- US-B1- 6 269 319

## Description

The invention pertains to train test platforms, especially for the integration testing of electrical, electromechanical and/or electro pneumatic train systems and components.

### Background of the invention

The complexity of modern railway trains has increased drastically over the past decades. Nowadays many systems and components are controlled and interconnected by a communication system comprising wiring, buses etc. In trains comprising multiple cars it is important to test the individual train systems and components with respect to their functionality not only as individual systems but also as a component of an interconnected integrated train system.

So far it has been common to build test stands or platforms for testing the individual train system on their own. US 6,269,319 B1 further discloses a reconfigurable integration test station for a plurality of vehicle components of an individual vehicle like an aircraft. The test stand is designed to be adaptable to different vehicle models. The unit under test is connected to the test station that simulates an environment for this unit under test. The simulated environment is used to simulate other components of the individual vehicle.

Such a test platform is capable of revealing some problems arising from interference of different components for example in an early development stage. Nevertheless, it is very tedious and time consuming and also error-prone in some respect to simulate all other components that might affect the unit under test. Unexpected influences and interference can usually not be detected due to short falls in the simulation of components that often do not "mimic" unexpected behavior. Problems multiply, when not only a grouping of components of an individual vehicle, but a multi-vehicle unit like a railway train is to be tested.

Therefore, there is a need for an improved test platform for testing the integration of train components especially in complex railway trains comprising multiple cars.

### Summary of the invention

According to one aspect of the invention a train test platform for a railway train comprising multiple cars is provided. Said test platform comprises:
- a car unit for each of the multiple cars representing a respective one of the multiple real train cars each,
- a train communication system connecting the car units and train systems,
- a supervisor unit, and
- reflective memory system,
   wherein the reflective memory system comprises a reflective memory table of the same memory space for each car unit and the supervisor unit, wherein said memory tables are kept synchronous by the reflective memory system, and
   wherein each car unit comprises
   an instrumentation unit
      said instrumentation unit providing the electrical break-out interfaces between the train communication system and all train components in the respective car,
      wherein the instrumentation unit further comprises:
         at least one car unit real-time engine;
            wherein said at least one car unit real-time engine is capable of reading from and writing to the respective reflective memory table of said respective car unit and; configured to monitor and/or to manipulate signals at these electrical break-out interfaces in real-time, wherein monitored signals are written to the reflective memory table and manipulations are carried out according to data read from the reflective memory table; and
         a simulation unit for car train systems not physically present in the respective car to simulate the electrical behavior of said non present car train system (for example to react on signals dedicated for said non present car train system and as to provide the respective signals that would be supplied by the respective real car train system simulated);
   wherein said supervisor unit comprises:
   a central system real-time engine interacting with the respective reflective memory table via reading of data for recording and/or monitoring and/or processing monitored signal data and via writing data to the reflective memory table for manipulating signals in car units and/or steer and/or control car train systems and/or platform components of instrumentation units.

According to a second aspect such a train test platform is used to perform integration testing of one or several actual car train systems prior to building a first real multiple car train.

According to a third aspect of the invention it is proposed to use such a train test platform to perform endurance testing to be ahead of the actual trains in service. This enables to detect unexpected wear out.

According to a fourth aspect of the invention such a test platform is used to test the integration of replacement components while actual trains are already in service.

According to a fifth aspect such a test platform is used to train service personal on real components and their behavior in the train environment. This can happen prior to putting actual trains into service or while trains are in service already.

The different aspects of the invention allow for the detection of possible design deficiencies, design errors, incorrect or incomplete specifications for certain components at an early stage pre production or while the actual trains of a certain model are already in service. Especially faults that occur randomly or very seldom can be replicated and verified by such a test platform by providing a complete or almost complete set of information on the signals and the status of all components monitored. Unexpected side effects and influences can be revealed. One advantage of such a train test platform over real train system is the ability to test degraded modes and/or failure modes of car train systems, train-wide systems, and the like. Further especially interferences between identical system in one car or different cars can be tested and detected. Those can usually not be detected in test stations of the prior art, as usually only one component of this kind is tested with a simulated environment.

### Definitions

A car unit of the test platform is not a real car comprising the complete structure of a railway wagon. A car unit comprises all components and systems that can be assigned to one car of a multiple car train. Thus the car unit comprises all or at least a majority of the most important operational and safety-related functional entities related to one car. These are the real or actual components of a train to be finally produced, which are also called production components or actual (train) components. These are also those components of the test platform assigned to a certain car unit that are used for monitoring and/or manipulating and/or simulating components of the respective car unit. The car unit also comprises those hard and or software components providing infrastructure to the respective car unit like power supplies, breakout boxes or reflective memory units of the reflective memory system assigned to the car unit.

A car train system is a train system that is located in one car unit. A component of a train-wide or multiple car-wide system can also be a car train system that is located in a respective car. Examples of car train systems are the brake systems (for example one brake system for each car), the bogie monitoring systems, the fire detection systems, the door systems, heating ,ventilation and air conditioning (HVAC), pantographs, driver desks, or train control and management systems (TCMS) to name some examples.

Car train systems can comprise several components located in different places in the actual car represented by the car unit.

A real-time engine is a software program executed on appropriate hardware to enable real-time reaction to input signals. I.e. the processing time is determined by the real-time engine and is not dictated by the computer scheduler like in stack oriented systems. The processing of an incoming signal is started immediately or at a point in time determined by the real-time engine. Delays due to resource limitations are supposed to be orders of magnitude lower than the anticipated processing time. Output signals are provided on time. Real-time engines used for simulation purposes closely mimic the timing behavior of the component simulated with regard to outputting signal responses when responding to input signals.

The term monitoring is used here for getting information about a signal without disturbing the signal or changing it. Monitoring a digital two level signal reveals the state of the signal, for example whether a wire carrying the signal is in a high voltage state or a low voltage state. Monitoring an analogue signal results in a value, for example the exact voltage level of a wire with respect to a reference potential. Ground or earth are usually used as reference potential or reference voltage having the value 0 or 0V. From monitoring a bus one receives, depending on the bus type, one or several data streams representing signal states or signal voltages. This stream or these streams can often be interpreted in view of a protocol, to receive meaning full data like commands, instructions, addresses, data etc. Thus the result of monitoring a bus depends on the amount of processing done to the raw monitored bus data.

The terms simulation or to simulate are used where a signal or signals are provided by a simulator not present in an actual train system. The signal or signals are created to provide representative information on the wire or buses that are simulated based on the system actual conditions, obtained from the monitored signals. Thus a real system or component is mimicked or emulated in terms of providing signals that would be associated with a functionality said real component would provide. The term simulation is used when the real component is missing.

The terms manipulation or to manipulate are used for situations, where at least one signal on a wire or bus is forced to a certain state or value. The term manipulation is used when a real component is present that supplies the signal manipulated. This signal is manipulated in case the signal is forced to a certain state or value regardless of the actual supplied value or state supplied by the real component. Usually the term manipulation is used only when a state of this signal forced is different from the intended state or value this real component provides.

The communication system of a train comprises the wiring, buses and power supply and serves the functionality that the different components and systems of the train can exchange signals. The communication system may comprise some basic, generally relay based, functionality. In this case the communication system is sometimes called ordinary train control (OTC) system. The ordinary train control (OTC) system, for example may comprise interlocking and protection circuits. This may involve isolation of electrical components and functions, for example to allow driving of a train from one cab only, when this cab is active. The ordinary train control may comprise some driver interfaces to control lights for example. In general, functions with a high safety integrity level are implemented by wiring and relay based interlocking making up the OTC. More advanced functions not requiring the highest level of safety integrity are implemented in other systems. It should be noted though that some complex functions with high safety integrity level may also be implemented using software components. Thus in general more sophisticated control and management functions are implemented in components not belonging to the communication system itself.

### Preferred embodiments

Full integration testing can be realized best in a test platform, in which the communication system comprises the actual bus-system or bus-systems as well as the actual inter-car and in car wiring except for cable length deviations where appropriate. Where appropriate means in this context that over lengths or slack of cables are minimized if possible. For some cables it might be necessary to be longer in the test platform than in a production car to allow for monitoring and/or manipulation of the signals carried.

Besides the communication system it is preferred that each car unit comprises the complete actual train control and management system including interlocks. Usually each car unit comprises one or several components providing this control and management functionality. For example car units may comprise the complete ordinary train control system(s) (OTC) as well as the complete actual train control and management system(s) (TCMS).

In a preferred embodiment the test platform is located in a building, preferably in one hall. Each car unit is assigned a certain area so that all car train systems belonging to that respective car are located next to each other. This resembles the actual train design best.

In a preferred embodiment the car units are located in a U-shaped or O-shaped manner. The supervisor unit is preferably located at the open end or between the first and the last train car. As the reflective memory system usually uses an optical loop to connect the different units hosting the respective memory tables of the shared memory space, this layout minimizes the length of the optical loop for the reflective memory system. Hereby latency effects are minimized. I. e. the time interval it takes to communicate a change in one reflective memory table to all other reflective memory tables is minimized.

It is advantageous to have the test platform equipped with all actual train systems used in the production train. Due to size, cost and other resource-limitations this is often not possible. Thus only a selected number of actual car train systems are installed in a test platform. Especially to test side effects on equal systems in the same car or in different cars, it is preferred to have at least for some train car systems several actual car train systems installed for testing in the test platform.

The primary scope of the test platform is in one embodiment on electrical integration and functional verification of the multiple-cars train design.

Preferably the test platform comprises one or several actual instances of car train systems out of the group: actual door system, brake system, driver desk, heating, ventilation, air conditioning (HVAC) system, for example a HVAC-control cabinet in combination with a HVAC cab unit, power supply system, for example a battery charger including batteries.

For certain components it is difficult to install all the mechanical components belonging to the respective train system. Examples are the brake system or the pantograph systems. In one embodiment therefore the test platform comprises one or several instances of the actual car train components at least partially. Preferred components are selected out of the group, pantograph, brake system, wherein missing actual parts are physically simulated. For a pantograph of the train in one embodiment, the production train computers are installed, but an electro-pneumatic based simulator is used to simulate the components from the pantograph lifting arms. With regard to the coupling of the simulator to the actual production components the simulator behaves like a real pantograph lifting arm. Thus, all signals send from the computers and back to the computers are identical in signal type and timing to a real pantograph lifting arm. In brake systems for example brake calipers can be simulated by a pneumatic simulator.

Systems in modern trains often comprise subcomponents that might not be communicating with their controller and or control component via a bus-system or other communication lines monitored by the test platform anyhow. Thus in a preferred embodiment of the test platform the instrumentation units also comprise break-out interfaces for connecting sub components of a car train system with its controller and/or control component, wherein that break-out interfaces can be monitored or manipulated by the respective at least one car unit real-time engine. This enables subcomponent testing or in depth testing of actual components and systems. This allows also manipulations of signals within a train system to facilitate degraded mode or failure mode testing. In depth monitoring helps in locating errors and to identify faulty components in case unspecified and or wrong functional behavior of car train systems is observed.

In a preferred embodiment the supervisor unit comprises a simulation engine to simulate train-wide behavior. Such an engine is for example capable to simulate a train speed on acceleration, or the deceleration on activation of an emergency braking. Thus, this central simulation engine provides data in real-time used by some other components in the train system. For example, brake system functions are dependent on the actual train speed. The heating ventilation and air conditioning system may be dependent on environment parameters like outside temperature, humidity or a driving status. The driving status can comprise for example information whether the train is traveling in the open or in a tunnel etc.

To enable endurance testing and systematic testing as well as for example simultaneous activation testing of different or competing systems it is of advantage to be able to have the testing automated and computer controlled. Thus, in a preferred embodiment the supervisor unit comprises a script engine to execute scripts to perform automated test sequences, usually via interacting with the central real-time engine.

Nevertheless in some situations it is also desired to be able to influence, i.e. manipulate, certain signals or to view, i.e. monitor, certain signals manually. Therefore in some embodiments the supervisor unit comprises a human machine interface capable of providing monitoring data of the multiple-car test platform in a human perceptible fashion and also capable of accepting human inputs to manipulate test train systems via interaction with the central real-time engine. The test platform implements a test train that comprises the actual train systems as well as the simulated train systems. Thus the monitoring data among others comprise data representing the behavior of this test train.

In a preferred embodiment the human machine interface is capable of providing monitoring data of the multiple car test train in a human perceptible fashion and capable of accepting human inputs to manipulate test train systems via interaction with the central real-time engine. In one embodiment the human machine interface comprises one or more touch screens to visualize monitoring data and at the same time accept user inputs. Preferably the touch screen or touch screens provide a multi touch capability. Those multi touch screens are capable to register several touches in different locations occurring on the screen simultaneously as separate input locations or traces. Those screens are able to detect touch gestures to increase the handling comfort for the human user.

It is preferred that all data present in the reflective memory table can be monitored and changed via the human machine interface.

Simulation for the complete train behavior is carried out in the supervisor unit. All simulation of car train systems though is carried out in the respective car units. Thus, in preferred embodiment the simulation units comprise a real-time car system simulation engine. This is capable to simulate by software all components not being present in the respective car. Interaction with the physical systems and the reflective memory table is carried out in one embodiment via the car unit real-time engine.

In some embodiments the simulation unit comprises at least one simulator that is at least partly realized by physical components other than a real-time engine.

Said reflective memory space shared by the car units and the supervisor unit comprises all signals monitored and all signals that might be manipulated. In a preferred embodiment the reflective memory space also comprises all status information, parameters variables etc. that are used to control and configure the components of the instrumentation units and/or train systems to be tested. This includes the complete actual systems as well as partly and completely simulated systems.

The instrumentation units comprise instrumentation racks as well as uninterruptible power supplies for all components of the test platform that are not present in the actual train. The uninterruptible power supply enables the test platform on loss of power or other failures to bring the hard and software for monitoring, manipulation, and simulation as well as the reflective memory system into a stable configuration that enables a safe shut down of the instrumentation.

The instrumentation units comprise as part of the break-out interfaces break-out boxes to carry out monitoring and manipulation of signals as well as interfacing of simulated signals that are not digital signals output to a bus system via an interface of the computer hardware. The car system real-time engine implemented on the instrumentation unit controls theses break-out boxes comprising the necessary hardware to spy on signals that are connected through the break-out box or to create a signal and connect it to the respective signal line in a manipulation/simulation situation.

Preferably the instrumentation units are configured to safely de-energize all interfaces in case of an emergency situation. This way safety for the personal working on the test platform can be realized.

The invention also provides a method for testing actual car train components in an integrated multiple-car train environment ahead of production of the first real actual multiple-car train or without an actual multiple-car train. The method comprises the steps of:
providing a test platform mentioned above, wherein the actual car train components to be tested are installed in the respective car units of the test platform, such that at least some of the signals used for controlling the functionality of the actual car train components to be tested can be monitored and/or manipulated by the test platform and/or at least some of the signals produced as feedback or as part of the functionality provided by said actual car train components to be tested, can be monitored,
powering up the test platform including the actual car train components to be tested; and manipulating or simulating at least one signal of one of the actual car train components to be tested or of any one of the train components simulated by one of the car units via the supervisor unit by changing at least one memory entry in the reflective memory space.

In one embodiment the manipulation is carried out via executing a script on hardware of the supervisor unit.

It is preferred that at least the signals monitored are recorded in real-time in the supervisor unit. This can for example be done by storing changes for signals monitored together with time stamps documenting the time of the change. Preferably also the status information as well as the manipulation signals are recorded in real-time. This enables complete reconstruction of events to evaluate the test results.

Some of the car components like a driver's desk in a cab unit comprise actuators for controlling and/or steering other train components. To enable certain tests and/or driver training etc. it is desired to be able to accept inputs by these actuators in one of the car units and, alternately, inputs created in the supervisor unit, either by manual input via the human machine interface or by automatic simulation and/or manipulation performed by a script engine. Thus, in one embodiment at least one car unit comprises at least one actuator to influence the behavior of at least one train component in an actual train, and wherein the break-out interface of the respective car unit is configured to alternatively enable or disable a signal input of said at least one actuator, and wherein the break-out interface is further configured to create an equivalent input signal under the control of the supervisor unit as a modification, when the actuator input is disabled.

In one embodiment the train component may comprise a visual human machine interface realized by a touch screen for example. To enable manipulations not noticeable by the person at this car component human machine interface, the human machine interface of an actual train component is modified by a software component to enable manipulated inputs in the car unit's human machine interface by the supervisor unit.

In one embodiment the location, which the steering/controlling of certain operational functions can be executed from, can be switched from supervisor unit to the operational means of a driver desk in one of the car units, wherein display functions indicating the status of real train components or simulated systems can be displayed in parallel on the supervisor's human machine interface and on a driver desk's human machine interface.

### Brief description of the drawings

- Fig. 1: shows a test platform overview;
- Fig. 2: shows a schematic concept of information flow in the test platform using a reflective memory system;
- Fig. 3: shows a test platform architecture illustrating the distinction between the test platform components and train components to be tested;
- Fig. 4, 4a: shows a schematic illustration of one test platform for one eight-car train and an enlarged section thereof, respectively;
- Fig. 5: illustrates the test platform software architecture from the platform instrumentation components up to the break-out interface to the train components to be tested;
- Fig. 6: shows a functional model of a break-out box used for signal adaptation;
- Fig. 7: depicts different test modes the test platform can be used in; and
- Fig. 8: shows a functional concept of a break-out box used to alternately accept inputs from an actual train actuator or the supervisor unit.

### Detailed description of the invention

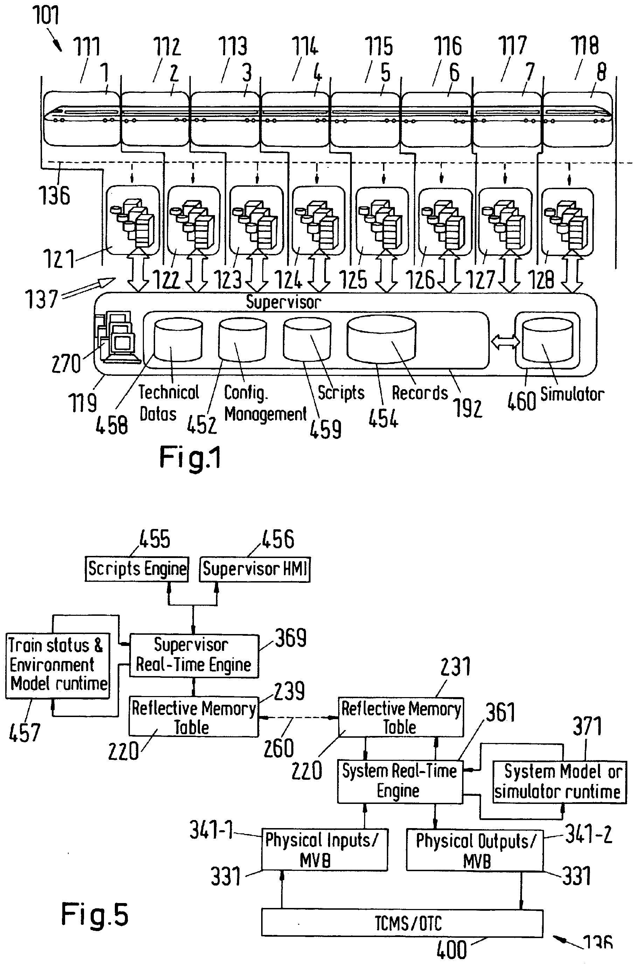

Fig. 1 shows overview of a multiple-car railway train test platform 101. The test platform 101 is adapted to a train comprising eight cars. The test platform 101 is thus structured in 8 car units 111 to 118. The pictograms 1 to 8 are representing each the respective car train systems comprised by the production train car represented by the respective car unit 111 to 118. For example the pictogram 1 of car unit 111 represents all or at least a majority of the most important operational and safety-related functional train components associated with the first car of the production train. For example this first car comprises among other car train systems a driver desk , brake systems, door systems, heating ventilation air conditioning systems (HVAC), train control and management system (TCMS) components, just to name a few. These components that are included in the integrated test to be performed by the test platform 101 are represented for the car unit 111 by the pictogram 1. Pictogram 2 consequently represents the car train systems of the car unit 112 representing the second car of the actual production train and so on.

Besides brake systems, door systems, HVAC systems, and TCMS components the second car does also comprise a pantograph but for example no driver desk. Thus the different cars of the production railway train may differ from each other. In the same manner the car units 111 to 118 differ to correctly represent the production train car associated therewith.

All cars are interconnected by a communication system 136 comprising bus systems, wires, etc to distribute signals and power. All these interconnections are referred to here as communication system 136. In the actual production train the communication system interconnects the different train systems and components. I.e. it distributes signals and power in the train. The communication system 136 serves the same purpose in the test platform as well.

The break-out interfaces between the test platform components and the actual train component (represented by pictograms 1 to 8) are located at this communication system 136, which is a train system itself. It is pointed out that the communication system is an actual train component also. Nevertheless, the test platform modifies this train system by providing the physical break-out interface components to be able to spy on, manipulate and/or simulate signals. To distinguish the components just used for testing from those components present in a real actual production train the components used for testing only will be referred to here as platform components. The components to be tested that are found in the real actual production train will be referred to as train components. It should be stressed at this stage that some embodiments of the test platform, when performing actual testing of train components, obviously comprise train components. Nevertheless, these components will be addressed as train components. Also components that are realized by simulation in the respective car units of the test platform are referred to as train systems.

Each car unit comprises an instrumentation unit 121 to 128. This instrumentation unit represents all platform components associated with the respective car or car unit 111 to 118. As will be explained in greater detail below the instrumentation units 121 to 128 provide the break-out interfaces to couple the communication system 136 with the train components to be tested. These break-out interfaces are used to monitor, i.e. spy on a signal, manipulate a signal, i.e. force a certain signal state provided by the test platform components, regardless of the signal state present actual train components provide, and or to simulate signals, i.e. force signal states provided by the test platform components in case real actual train components are not present in the test platform. The instrumentation units 121 to 128 comprise all components necessary to perform the monitoring, manipulation and simulation in the respective car unit 111 to 118.

All testing is controlled centrally. The components needed for this purpose are provided by a supervisor unit 119. The supervisor unit 119 provides hardware, especially computer hardware 270, to realize at least one human machine interface, and memory 192 to store test data in a record data base 454, especially monitoring data, but also configuration data in a configuration management data base 452 and other technical data 458. Further the hardware is capable of controlling automated testing for example by executing test scripts 459. Thus, the supervisor unit 119 comprises hardware for a central simulator 460 that interfaces with real-time operating systems to allow for automated test script execution, combined with the real-time simulation of environment behavior of the complete train. In one embodiment the automated test routines are executed on computers with non-real time operating systems. These might for example be equipped with operating systems common for personal computers and/or workstations (for example with an operating system of the operating system family sold by Microsoft, Inc. under the trade name "Windows"). In this embodiment the human machine interface is also controlled by non-real time operating system computers. A test script engine may also be provided and executed on a computer using a non-real time operating system.

A reflective memory system 137 is used to exchange any data between test platform components of the different car units 111 to 118 themselves as well as to exchange data between these platform components of the car units 111 to 118 and the supervisor unit 119.

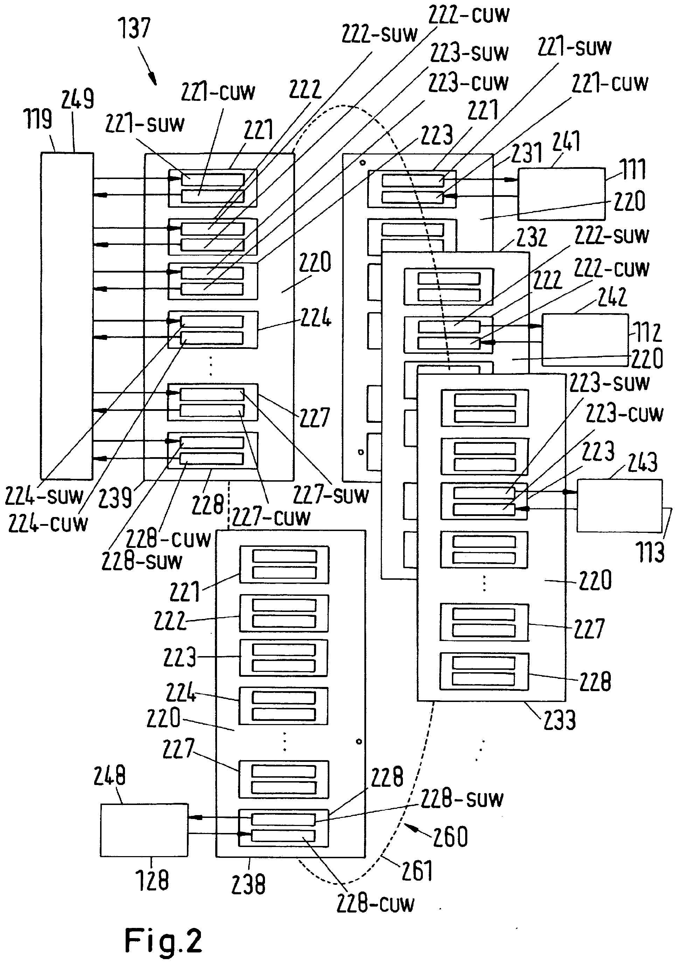

The reflective memory concept used will be explained in more detail with reference to Fig. 2. Fig. 2 shows a schematic concept of information flow in the test platform using a reflective memory system 137. There exists one memory space 220. This one memory space 220 is divided into subspaces 221 to 228 allocated to each of the car units 111 to 118. In these subspaces 221 to 228 all data associated with the respective car unit 111 to 118 are saved. I. e. all monitored signals are stored here. Further, parameters for the break-out interfaces with the train components as well as of the test platform components are saved here. Some parameters might be coded in simulator model software executed on the real-time operating system computers in the respective car units 111 to 118. Instruction from the supervisor unit 119 to any one of the car units 111 to 118 are transferred by writing data to a designated memory location for the exchange of such instructions. In some embodiments there might be a subspace for common information that is not specific to one car. This subspace could be assigned to the supervisor unit. It should be appreciated that the assignment of subspaces leads to a well structured memory space. Usually only the respective car unit 111 to 118 a certain subspace 221 to 228 is assigned to and the supervisor unit 119 will access this certain subspace 221 to 228 in write mode. Usually even in read mode only these two entities will access the respective sub space. E.g. the subspace 221 assigned to the car unit 111 will be accessed by the components of the car unit 111 and by the component of the supervisor unit 119 only. Nevertheless, in principle all units 111 to 119 can access the same memory space. It is also advantageous to organize the subspaces 221 to 228 in such a fashion that there exist a car unit write section 221-cuw to 228-cuw and a supervisor write section 221-suw to 228-suw. This way it is possible to achieve that each memory location is written to by entity only.

Physically the reflective memory system 137 is realized by providing "identical copies" of the memory space in from of memory tables 231 to 239. These are kept in local reflective memory system components 241 to 249. These local reflective memory system components 241 to 249 are connected in a loop 260 via an optical cable 261. As soon as one of the different car units 111 to 118 or the supervisor unit 119, i.e. one of the respective components of the car units 111 to 118 or the supervisor unit 119 writes to any memory location in the shared memory space 220, the respective memory table 231 to 239 is changed. The memory system 137 is designed to keep all memory tables 231 to 239 synchronous with the least possible delay.

It is assumed for explanation purposes only that, for example, car unit 112 representing the second car in the actual production train is writing to its respective subspace 222 of the memory space 220 in the local memory table 232. This memory table 232 is kept in the local reflective memory system component 242 in the car unit 112. As soon as the local reflective memory system component 242 detects the write access to the local memory table 232 it communicates the memory change via the optical loop 260 to the next local reflective memory system component 243 in line. This updates its own local copy of the memory space 220, i.e. it local memory table 232 and also communicates the change to the next local reflective memory system component 244 in line. In this way the change or more correctly the information about the change travels in the loop until it reaches the local reflective memory system component 242 the change was originally performed at. This local reflective memory system component 242 removes the change information from the information stream passed in the loop 260 from local component 241 to 249 to local component 241 to 249.

It will be appreciated by a person skilled in the art that it would be possible to have two or more local copies of the reflective memory space 220 in one car unit 111 to 118 or the supervisor unit 119. This might be advantageous when certain train components to be tested have to be located separated of each other, for example, due to safety reasons.

Usually the physical components of the reflective memory system that are assigned to a car unit 111 to 118 are located in the respective instrumentation unit 121 to 128, which usually comprise one or more racks. Thus instrumentation units 121 to 128 comprise and provide the interface between the respective car unit 111 to 118 and the supervisor unit 119.

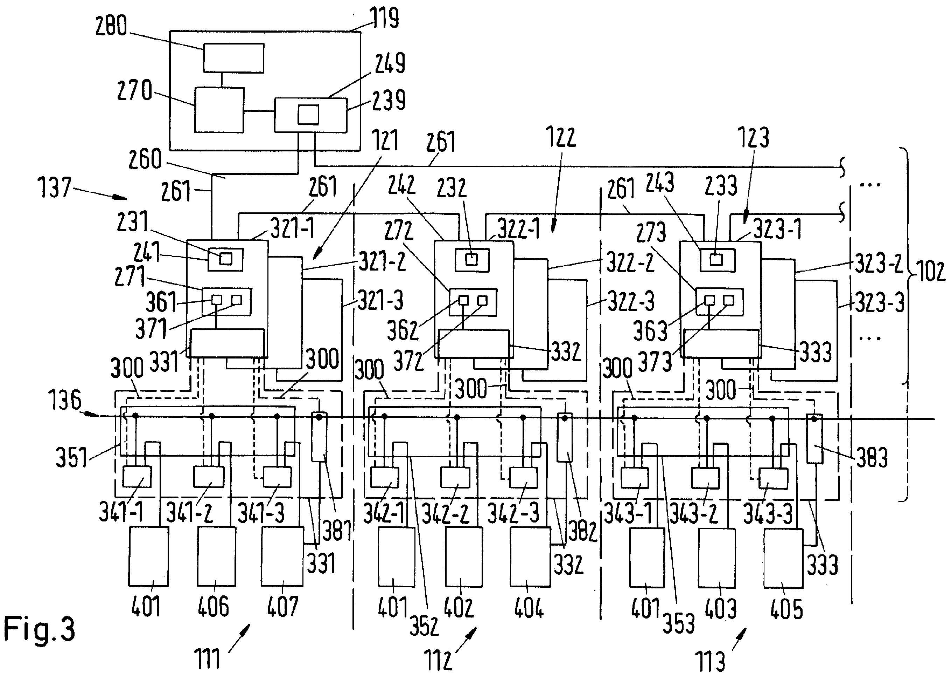

Fig. 3 depicts the hardware architecture of the test platform in a schematic fashion. Of the multiple car units only three are depicted. The hardware of the supervisor units 119 comprises at least one computer 270 capable to host a real-time operating system (RTOS) and further input and output devices to realize a human machine interface. Preferably the human machine interface comprises computer hardware to realize a visual menu oriented human machine interface capable to display all signal monitored and to accept inputs to manipulate all signals manually that can be manipulated. In one embodiment this human machine interface comprises at least one touch screen 280. Further, in case parameters can be set for certain systems or components a supervisor unit according to a preferred embodiment comprises the human machine interface configured to enable manual changes as well. Further the supervisor unit 119 preferably comprises computer hardware to enter or execute code. This hardware serves as terminal for a real-time engine, as terminal for a simulator engine, and/or as a script engine executing automated test procedures in one embodiment. Further, hardware for storing test results, technical data, configuration data, and documentation is provided. The supervisor unit also comprises in some embodiments interfaces for distributing the test data collected to other computers, for example, via a computer network etc. The local reflective memory system component 249 is connected with the hardware capable to host a real-time operating system. The local reflective memory system component 249 links the supervisor unit 119 to the different car units 111 to 113 via the reflective memory system 137.

The depicted car units 111 to 113 comprise an instrumentation unit 121 to 123 each. The instrumentation units 121 to 123 comprise one or more instrumentation racks 321-1 to 323-3. In the depicted example each instrumentation unit, for example, comprises three instrumentation racks 321-1 to 321-3. The instrumentation unit 121 of car unit 111 for example comprises the instrumentation racks 321-1, 321-2 and 321-3.

These instrumentation racks 321-1 to 321-3 of the car unit 121 comprise as the test platform components, for example, the respective local reflective memory system component 241 and the computer hardware 271 to host a real-time operating system. On this computer hardware 271 the real-time engine managing the access to the reflective memory table 231 is executed. It should be pointed out that these real-time engines of the car units are completely separate from the reflective memory system 137 itself and just control the read and write operations to the reflective memory tables 231 to 233. The reflective memory tables 231 to 233 themselves are used like normal random access memory by the respective real-time engines.

The instrumentation units 121 to 123 provide all hardware including the break-out interfaces 331-333 for monitoring the signals, for manipulating signals, or for simulating signals at the communication system 136.

These break-out interfaces 331 to 333 comprise different components. Each car unit comprises at least one terminal block 351 to 353 for physically interfacing the signal lines, wires etc. of the communication system 136. These terminal blocks are used for routing purposes. I.e. signal lines of the communication system are connected to the signal lines of other actual train components 401 to 407 present in the respective car units 111 to 119.

In case any spying and/or manipulation of signals coming from or directed to any actual train component 401 to 407 is intended a so called break-out box is interconnected in the signal path between the communication line of the communication system 136 and the signal line to and/or from the actual train component. Further signal lines of train components may be routed via the terminal block 351 to 353 of the respective car unit 111 to 113 to enable "extra" routing via break-out boxes for spying and/or manipulation.

In some cases the distinction between signal lines or wires of the communication system and signal lines or wire of a train component is difficult. Regardless of this distinction spying and manipulation can be realized in both cases with the same kind of hardware and software structure.

For monitoring and manipulation and for interfacing simulated signals said so called break-out boxes 341-1 to 341-3, 342-1 to 342-3, 343-1 to 343-3 are provided. The number varies according to the signals and/or actual car components 401 to 406 spying, manipulation and/or signal simulation is to be carried out on. Such break-out boxes can also be used to provide physical signals that are simulated in the respective car unit 111 to 113 at respective wires of the communication system 136. Bus signals spied on, manipulated or simulated can usually be captured or respectively be provided by an interface module standardized for the respective bus. Such interfaces are called break-out bus interfaces. In some cases of manipulation of bus signals, break-out boxes might be necessary to "replace" the original signals provided by the manipulated signal.

The break-out boxes 341-1 to 348-j (j being a natural number for counting the break-out terminal of car unit 118) as well as the break-out terminal blocks 351 to 358 can be considered as part of the respective break-out interfaces 331- 338, by which the train components as well as the simulated components are connected to the communication system 136, i.e. the buses and wires etc.

Monitoring is carried out in such a fashion that it is completely transparent to train system tested. I.e. the system is uninfluenced by the monitoring action. In case of manipulation this is done in a fashion that the system components can not detect that the signal is not stemming from the component that is supposed to supply the respective signal, apart from maybe detecting a signal out of specification. Such signals out of the specification are provided intentionally to induce a degraded mode or a failure mode. All spying and manipulation is carried out at the break-out interfaces 331 to 333 provided by the respective instrumentation units 121 to 123. In case a signal is to be spied on or is to be manipulated these actions are carried out through one of the break-out boxes 341-1 to 343-j. One such break-out box is explained below in greater detail. The actual connection to the actual train components to be tested is established via dedicated break-out boxes 341-1 to 343-3 and the break-out terminal blocks 351 to 353. Thus, the original connectors of the actual train components, in case there exist any, can be used at the break-out terminal blocks 351 to 353 of the break-out interfaces 331 to 333 provided by the respective instrumentation units 121 to 123. The break-out terminal blocks 351 to 353 are preferably configured to accept actual plugs or connectors in case the actual car components 401 to 406 are equipped with any kind of plugs or connectors at their signal lines and/or wires.

The communication system 136 that is preferably an actual train component or at least constructed functionally identical and more preferably also structured physically identical is connected to the break-out interfaces 331 to 333 via the break-out boxes 341-1 to 343-3 and via standardized break-out bus interfaces 381 to 383 used for spying and/or manipulation of buses of the communication system 136. In some cases break-out boxes may also be used to spy on communication lines realized as serial and/or parallel bus system.

Among the actual train components or systems 400 tested in one embodiment are the train control and management system (TCMS) 401, the heating, ventilation, air conditioning (HVAC) 402 system or subcomponents like the HVAC-control rack and the respective saloon module or cab module, brake systems 403, pantograph systems 404, power supply systems 405 like the battery charger and the batteries, the driver desk 406, the door system 407. Other systems that might be present in other embodiments may comprise the fire detection system, the bogie control system, toilet systems, internal automatic doors, entertainment systems, intercom systems, general lighting, traffic signal related systems just to name a few. It should be appreciated that any number and combination of actual train components be tested. Some or all components that are not present may be simulated. Simulation may be carried out in software and or in a combination of software and hardware. It is also possible to augment actual train components with hardware and/or software simulation components to realize systems equivalent to actual train components.

Fig. 3 shows that the break-out interfaces 331-333 and more precisely the break-out boxes 341-1 to 343-3, and the break-out bus interfaces 381 to 383 constitute the dividing line regarding the hardware between the train components 400 and the platform components 102. The break-out boxes 341-1 to 343-3 may partly or all be located physically at train component racks etc. even though they are considered to be part of the break-out interfaces 331 to 333 und thus of the instrumentation units 121 to 123. Signal and control lines 300 are connecting the break-out boxes 341-1 to 343-3 to the computing 271 to 273 the car unit real-time engines 361 to 363 are executed on.

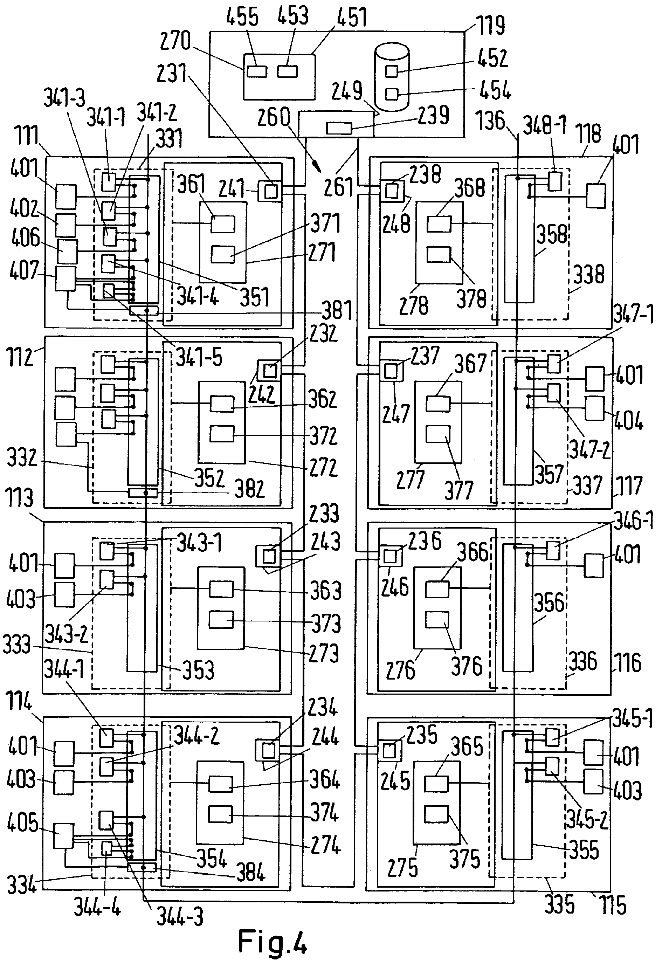

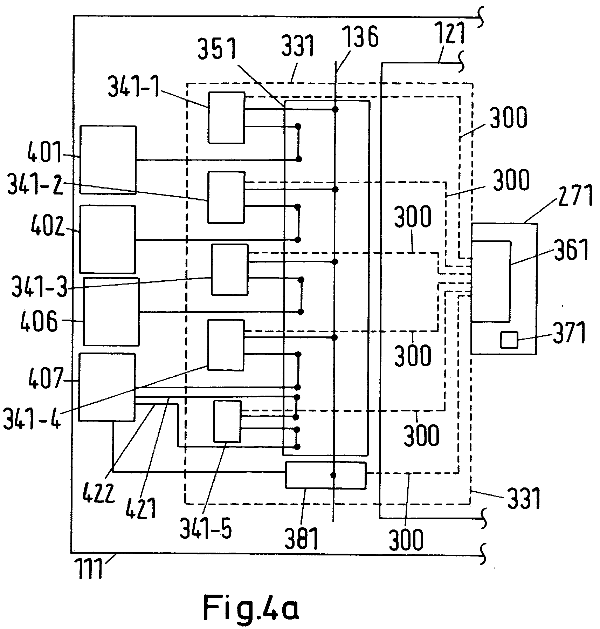

In one embodiment depicted in Fig. 4 a test platform for an eight car train is realized. The test platform 101 comprises a pre-selected set of real components 400. These components are configured functionally identical to the production train. The actual train components 400 installed comprise the wiring, interlocking, piping (if for example brake control is handled pneumatically) of the communication system 136, and the train control and management systems 401 for all eight cars. The installation is functionally identical to the production train, except where impossible to realize at reasonable effort. For example cables and pipes are shortened to avoid slack cables or over lengths. Components within each car as well as the cars themselves are interconnected by the communication system 136 in a configuration functionally identical to the production train, except where impossible to realize at reasonable effort. The wiring including buses, the power supply and piping, as well as some basic relay based functionality integrated into the wiring will be referred to as communication system 136. As stated above such a communication system 136 is some times also called ordinary train control (OTC) system.

The instrumentation units 121 to 128 comprise instrumentation racks 321 to 328. These instrumentation racks 321 to 328 comprise, among other things, the hardware required for the break-out interfaces 331 to 338 for connecting the wiring and bus interconnection of the communication system 136 with the actual train components 400. The instrumentation racks 321 to 328 also comprise the hardware 271 to 278 hosting the car unit real-time engines 361 to 368. These are controlling the break-out boxes 341-1 to 348-k for spying on signals and for manipulating signals at the respective break-out boxes 341-1 to 348-k. The car unit real-time engines 361 to 368 are capable to read and write to the respective memory table 231 to 238 hosted in the respective local reflective memory system components 241 to 248 of the memory system 137. Thus, each instrumentation unit 121 to 128 comprises a local reflective memory system component 241 to 248. The reflective memory system 137 is used as the "backbone" for the information exchange between the platform components of instrumentation units 121 to 128 and supervisor unit 119.

The purpose of the instrumentation units 121 to 128 and the instrumentation racks 321 to 328 is to simulate the system signals at the car level and provide the following main functions:
- communicate the status with all other instrumentation units 121 to 128 and racks and the supervisor unit 119 by using the reflective memory system 137;
- run simulation software on a real-time operating system (RTOS);
- provide the electrical break-out interfaces 331 to 338 (physical inputs/outputs and buses) with physical interfaces in the form of the break-out boxes 341-1 to 348-k, break-out computer interfaces 391 and the break-out bus interfaces 381 to 388 for interfacing the train systems 400 and the communication system 136 ;
- provide an uninterruptible power supply (UPS) for allowing the instrumentation units and racks to bring the electrical interfaces to a predefined configuration before shutting down during a power outage;
- provide an emergency power-off mechanism to safely de-energize all electrical break-out interfaces 331 to 338.

The train systems 400 installed or incorporated into a test platform pose a strategic selection of the production train systems. Depending on the objectives of the test programs to be carried out, different train systems can be installed. The signals of the train systems not installed are simulated when required to achieve the objectives of the test program.

As an example, the test platform depicted in Fig. 4 comprises components of the following train systems:
- Train control and management system (TCMS) 401. All components required for the production train are installed in all car units 111 to 118;
- driver desk 406: one driver desk 406 of an end car is installed; the second one of the second end car is simulated only.
- pantograph 404: for both pantographs 404 of the train, the production train computers are installed, but an electro-pneumatic based simulator is used to simulate the components form the pantograph lifting arms.
- HVAC systems 402: the production train HVAC control cabinet from one car is installed as well as the production train HVAC cab unit. The HVAC saloon unit is simulated.
- fire detection system: the fire detection system signals are simulated; no production train components are installed.
- bogie monitoring system: the bogie monitoring system signals are simulated; no production train components are installed.
- Brake Systems 403: for 4 cars the production train components of the brake system 403 are used, except for some components that are simulated instead by electro-pneumatic components. The electro-pneumatic components simulate the behavior of the missing components. For example the brake calipers are simulated. The brake system for the remaining 4 cars is simulated completely.
- Door systems 407: a production train door system 406 for one of the twenty-six doors is installed. The remaining 25 doors are simulated.

The supervisor unit 119 represents the user interface of the test platform, from which manual and automated testing can be performed. The supervisor unit 119 comprises in this embodiment:
- a human machine interface (HMI) 451 from which signals can be monitored and manipulated;
- a configuration management database 452 that comprises software and data to manage the configuration of the test platform 101;
- a test scripts application or test script engine 453 to allow automated test execution, for example using a test script,
- a record database 454, where all the signals and data from the test execution are stored;
- a simulator 455, which runs global simulation models, which apply to all cars, in contrast to the simulations carried out in the different car units 111 to 118, which run local simulation models applying to the respective car unit (represented production car) only.

The purpose of the supervisor unit 119 is to simulate the overall environment and train status in the test platform 101, and provides the following main functions:
- recording of the train status on instrumented signals in the record database 454;
- configuring the train with a configuration manager (e.g.: number and order of cars, instrumentation racks setup...);
- automatic testing using the script engine 453;
- simulating the overall train-wide behavior and environment conditions;
- steering of all other instrumentation units 121 to 128 and instrumentation racks 321 to 328 by using a reflective memory system 137;
- monitoring the status of all other instrumentation unit racks by using the reflective memory system 137;

The primary focus of the test platform described is on the TCMS (Train Control and Management System) 401, the communication system 136 with enhanced functionality OTC (ordinary train control) system, the brake system 403, the door system 407, the driver desk 406, the power supply (battery and battery chargers) 405, the pantographs 404, and the HVAC (heating, ventilation, and air conditioning) system 402. To complement the missing components car system model engines 371 to 378 are used for simulating them.

The test platform can not only be used to minimize the development risk by testing fully integrated systems against customer requirements well in advance of the first dynamic testing production train, but also to perform advanced test verification against the functional vehicle design specifications (FVDS), including normal modes, degraded modes and failure modes. A large part of the test program is based on functional negative testing and design robustness testing.

Fig. 4a shows an enlarged section of the break-out interface 331 of car unit 111. It can be seen in detail that the signal lines of the train components 401, 402, 406, 407 are connected to the communication system 136 via the break-out terminal block 351 and the respective break-out box 341-1 to 341-4. Further to be able to spy on inner system signals for example a push button signal directly belonging to the door system 407 the signal lines 421, 422 are connected to a break-out box 341-5 via the break-out terminal block 351. In this case the break-out box 341-5 is not connected to the communication system 136 as the signal lines 421, 422 are considered to be parts of the door system and not of the communication system 136.

Further the door system 407 is connected to communication system in this example via break-out bus interface 381. It should be understood, that the other car systems 401, 402, 406 could also be connected additionally or alternatively to the break-out boxes 341-1 to 341-4 to the communication system 136 via break-out bus interfaces or break-out computer interfaces.

In this enlargement further the signal and control lines 300 are shown that connect the break-out boxes 341-1 to 341-5 and the break-out bus interface 381 with the computer 271 the car unit real-time engine 361 is executed on. In most other figures except Fig. 3 these signal and control lines 300 are not shown to not obscure the figures.

With regard to Fig. 5 the software architecture of one embodiment will be explained. Fig. 5 shows the supervisor unit software architecture as well as the software architecture of one car unit. The software of actual train systems tested that are not simulated is not shown.

The scope of the supervisor software is to provide the human-machine interface to allow access to the test platform data and functionalities from a single location. The supervisor software includes the following capabilities:
- a script engine 453 allows the execution of automated scripts to perform automated test sequences. This script engine automatically generates a report with the results of the test execution;
- a supervisor human-machine interface (HMI) 456 allows access to test platform data and allows the manual operation of the test platform and manipulation of all variables;
- a train environment model engine 457 is used to run real-time algorithms to simulate train wide behavior (such as speed and acceleration). The results of those algorithms are used at car level and system level simulations.
- a supervisor database (not shown) is used to store the test platform monitored signals and test results.
- to read from and to write to a reflective memory table 239, which is a copy of the memory space 220 shared between all connected systems (supervisor unit 119 and car units 111 to 118). Each connected computer system can read or write directly in this memory space. The supervisor's reflective memory table 239 and the car units' reflective memory tables 231 to 238 communicate through a high speed fiber optic network 260 in a ring configuration.
- a supervisor central real-time engine 369 allows the coordination of information coming from the script engine 453, the supervisor HMI 456, the train environment model engine 457, the supervisor database (not shown) and the reflective memory table 239.

The scope of the software in the instrumentation units (instrumentation unit 121 is shown only) is to deploy at the car level, process commands and instructions coming from the supervisor unit 119 and other instrumentation units (not shown) and to manage the hardware break-out interface 331 of the instrumentation unit 121. The instrumentation unit's software provides the following capabilities:
- a car system model engine 371 is used to run real-time algorithms to simulate system specific behavior of train components simulated only. The results of those algorithms are directly outputted to the actual train components 400 through the communication system 136 or send back to the supervisor unit 119 through the reflective memory system 137.
- the ability to read from and write to a reflective memory table 231, which is a copy of the memory space 220 shared between all connected systems (supervisor unit 119 and car units 111 to 118, i.e. the instrumentation units 121 to 128). Each connected computer system can read or write directly in this reflective memory space 220. The supervisor unit's reflective memory table 239 and the instrumentation unit's reflective memory table 231 communicate through a high speed fiber optic network 260 in a ring configuration.
- a car unit real-time engine 361 allows the coordination of information coming from the reflective memory table 231, the train environment model engine 371 and the hardware break-out interfaces 331.
- The car unit real-time engine is capable to control the signals at the break-out interface 331 comprising a break-out box 341-1 hardware interface to receive signals from the communication system136 and another break-out box 341-2 to output signals to the communication system 136. By this the break-out interface 331 interfaces via its break-out boxes through the communication system 136 with the actual train components 400 to be tested and/or systems simulated at least partly in hardware.

The break-out interface between the actual train components or simulated systems and the communication system comprises break-out boxes as mentioned above. The actual connection to a train component is realized via dedicated terminal blocks. The connection between the communication system i.e. the wiring and/or the bus or buses is realized via the break-out boxes that are realized according to the specific needs. Different types of signals need different types of handling. On certain connection lines spying will be desired only. On other lines spying and/or manipulation will be desired. Thus, different signal adaption models are realized in the break-out boxes 341 to 348. The break-out boxes comprise the wiring, relays and other electronics to spy on signals (monitoring) or to manipulate signals. The break-out boxes 341 to 348 are connected to computer interfaces of the machine executing the car unit real-time engine 361 to 368.

A signal adaptation model is a generic interconnection concept, which contains no specific signal name or component name. This signal adaptation model can be applied to one or multiple specific real electrical connections in a building block manner. Simpler adaptation models can be grouped to create more complex signal adaptation models.

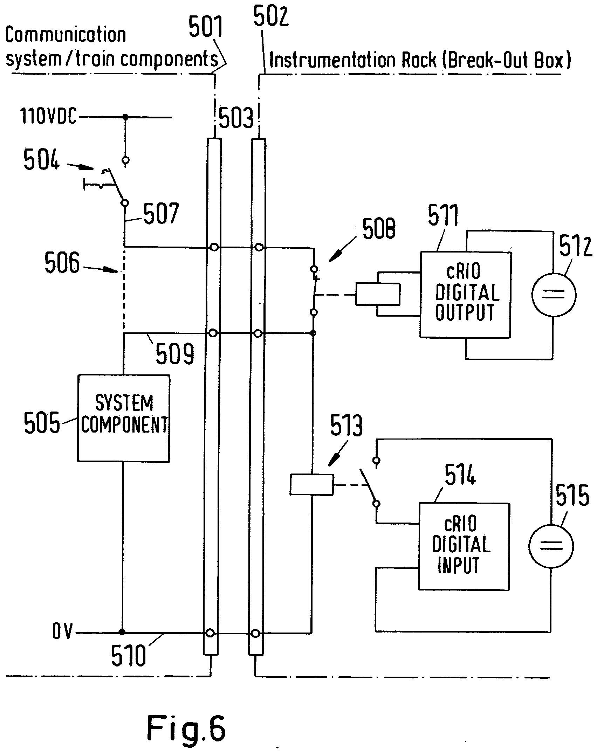

Figure 6 shows an example of signal adaptation model, for the case of a "manipulate a normally closed line and spy on" model. In this signal adaptation model, the train component hardware 501 is connected through the break-out box 502 located in the instrumentation unit 121 to 128 through interconnection break-out terminal blocks 503. In the given example, a contactor 504 was originally activating a component 505 through its original wire 506. In order to manipulate the output 507 of this contactor 504, the original wire 506 is removed and the contactor output 507 is routed to the break-out box 502 via the terminal block 503. In the break-out box 502 the wiring passes through a normally closed relay 508. The circuit continues through the terminal block 503 again to the input 509 of the system component 505. The contactor output 507, the systems component input 509 and a zero-voltage reference line 510 are interconnected at the dedicated break-out terminal block 503.

The normally closed relay 508 is controlled by a CRIO module 511 powered by an internal power supply 512. CRIO is the abbreviation for compact real-time input output. The CRIO module 511 is itself controlled by the car unit or instrumentation unit system real-time engine. The signal and control lines of this connection are not depicted. When de-energized, the normally closed relay 508 does not modify the contactor output 507. However, when energized, the normally closed relay 508 opens the connection between the contactor output 507 and the input 509 of the system component 505.

In addition, this signal adaptation model includes a spy-on option, which allows the reading of the contactor output 507 through a spy relay 513. This spy relay 513 is connected to another CRIO module 514 powered by another internal power supply 515. Again the signal and control lines connecting the CRIO Module 514 to the respective car unit real-time engine are not shown.

In this example the break-out box 502 is capable of removing a contactor output 507 of a connector 504 from its intended destination, a system component input 509 of the system component 505, while also measuring the voltage inputted to a system component 505. For the embodiment of a test platform like the one shown in fig. 4, these generic signal adaptation models were developed.

With these kinds of break-out boxes different functional interconnection modes can be realized.

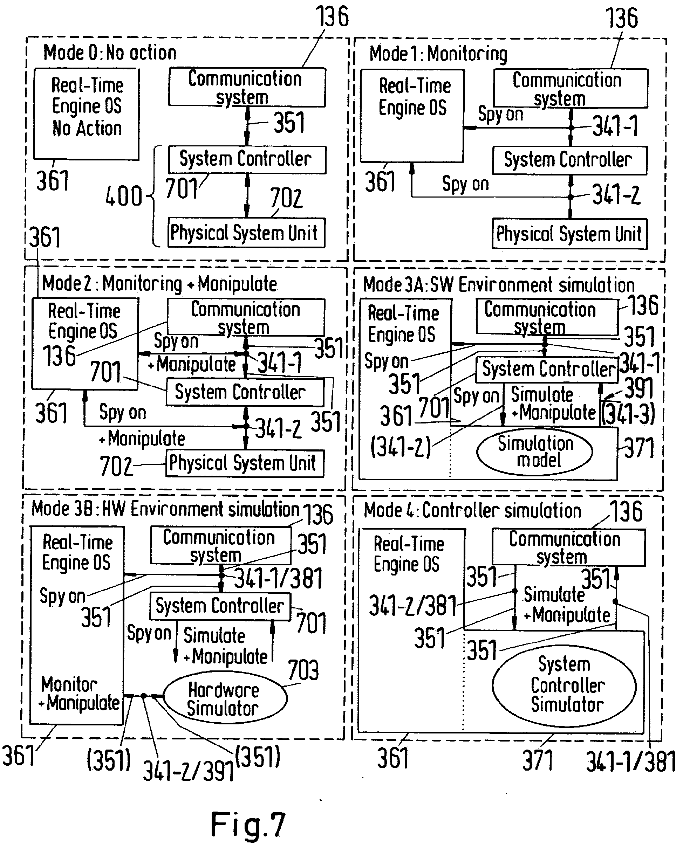

Fig. 7 shows the different functional interconnection modes developed for such a test platform. These modes were developed on the assumption that the actual train systems 400 to be tested comprise an actual physical system controller 701 and some other physical system 702 connected to the system controller 701. These functional interconnection modes are:
- Mode 0: No action - No monitoring: This mode is used when the real physical hardware 702 is connected to the real controller 701, but there is no need to monitor the inputs and outputs
- Mode 1: Monitoring - This mode is used when the real physical hardware 702 is connected to the real controller 701. The platform will monitor all input and output (I/O) activities between the controller 701 and the physical world 702 and/or to the Communication system 136 via break-out terminal block 351 and the break-out boxes 341-1, 341-2.
- Mode 2: Monitoring + Manipulate - This mode is used when the real physical hardware 702 is connected to the real controller 701. It will monitor all to be tested (I/O) activities between the controller 701 and the physical world 702 and/or to the communication system 136 via break-out boxes terminal block 351 and the break-out boxes 341-1, 341-2. These will also be used to manipulate the necessary signals between the controller 701 and the physical world 702 and/or to the communication system 136.
- Mode 3A: Software environment simulation - This mode simulates the environment (using a software model) of the controller 701. I.e. the physical hardware is simulated via a car system model engine 371 and all the I/O connected to this controller 701 is manipulated via break-out terminal block 351 and break-out boxes 341-2, 341-3 and/or break-out computer interfaces 391. The I/O between the communication system 136 and the controller 701 is spied on via a break-out terminal block 351 and break-out box 341-1 and/or a break-out bus interface 381.
- Mode 3B: Hardware environment simulation - This mode is identical to mode 3A except that this mode simulates the environment (using a hardware simulator) of the controller 701 via dedicated simulation hardware 703 and all the I/O connected to the real controller 701. Spying on the I/O between the communication system 136 and the controller 701 is carried out via a break-out terminal block 351 and break-out box 341-1 and/or a break-out bus interface 381. Monitoring and/or manipulation of the simulation hardware 703 is carried out via a break-out terminal block 351 and break-out box 341-2 and/or break-out computer interface 391.
- Mode 4: Controller simulation - This mode simulates the behavior of the controller and all I/O (including I/O to the multifunctional vehicle bus (MVB) or other buses of the communication system 136). Interfacing is performed via break-out terminal block 351 and break-out boxes 341-1, 341-2 and/or break-out bus interfaces 381. The simulation is done by a car system model engine 371.

It will be appreciated that the different functional modes can be put to use in different combinations to achieve testing goals set out.

In order to maximize the usage of the test platform, the driver desk 406 of the car unit 111 as shown in an embodiment depicted in Fig. 4 may comprise the following components:
one or several switches, one or several buttons, a master control thrust lever, and a so called Interface Driver Unit (IDU) realizing a human machine interface by using a touch screen in the driver desk. The components are instrumented in a way that allows three driving modes:
   - a manual driving mode from the driver desk (like a real driver). This is referred to as manual cab driving mode;
   - a manual driving mode from the supervisor HMI (using mouse). This mode is referred to as manual supervisor mode;
   - an automatic driving mode from the supervisor script engine. This mode is referred to as automatic mode;

It is necessary to provide for manipulation and/or spying capabilities on these input and output hardware components. For electromechanical actuators of the driver desk such as, but not limited to, push-buttons, switches, master control thrust lever etc. break-out boxes and/or break-out computer interfaces or break-out bus interfaces are used depending on the connection of these electromechanical actuators to the communication system 136 in the actual train environment.

The monitoring and manipulation of the IDU human machine interface can be realized in different ways. It is possible to use break-out bus interfaces and or break-out computer interfaces to monitor and manipulate the signals eventually output and/or received via the communication system 136. The internal IDU human machine interface can not be monitored or manipulated though. Thus it is preferred to additionally use a specially developed software application to perform the monitoring and manipulation at the IDU level.

In one embodiment the different modes are realized as follow:
- In the manual cab driving mode performed at the driver desk, all manipulations are disabled and the driver desk commands can be executed as a driver would do it in the train. The spy on capabilities are however still active, so the driver commands can be displayed on the supervisor HMI and also be recorded on the supervisor database. These data can be used as part of the driver training program to evaluate the driver behavior.
- In the manual supervisor mode all inputs are performed manually via the supervisor HMI.
- In automatic driving mode all "inputs" are provided from the supervisor script engine. In one embodiment all inputs and/or manipulations are activated allowing the control from the supervisor unit either manually via the HMI or alternatively automatic from the supervisor script engine.

In one embodiment inputs may only be provided either from a physical driver cab component or the supervisor unit. For different components or groups of components this exclusive "control decision" may be taken differently. Thus for each component the driving mode can be selected individually. Different components can be assigned to different driving modes at the same time. For example, the master control thrust lever could be controlled by the supervisor script engine while the open door push button could be controlled by the driver from the driver desk.

In a more sophisticated embodiment at least in the manual driving mode manipulations originating from the supervisor unit are possible as well. Such design allows the creation of driver training scenarios where faults could be injected in the driver commands to see how the driver would react to them.

In principle it is possible to have embodiments where one component could be assigned to several drive modes at the same time. I.e. inputs could be performed either by the actual control component or by the computers of the supervisor unit (either manually or automatic) However this could lead to conflicting behavior. Thus, the supervisor units manipulation should always take precedence over the manual inputs performed at the driver cab in case of conflicting behavior.

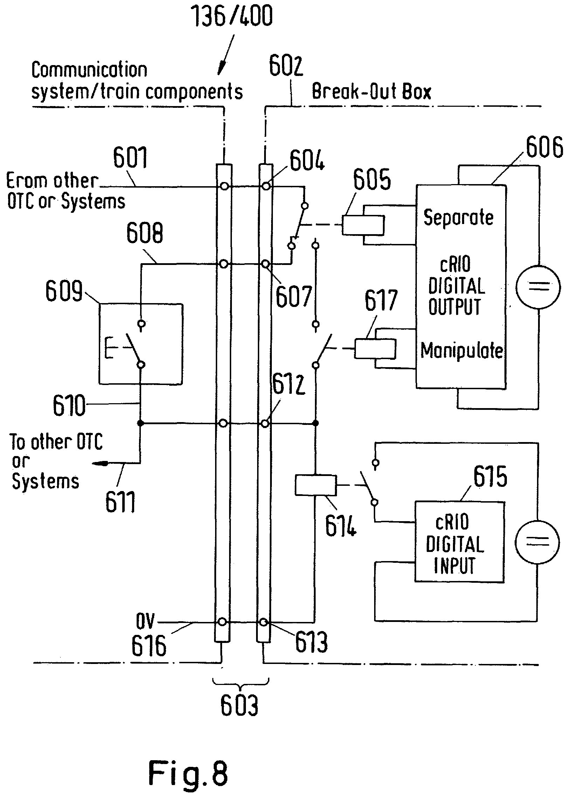

Fig. 8 depicts the break-out box concept of the functional interconnections a for driver desk electromechanical actuator, where the actuator input is exclusively input via the actuator or via the test platform.

A signal line 601 of the communication system 136 is routed via the break-out terminal block 603 to a break-out box 602. The input 604 of the break-out box 602 is connected to a separation relay 605 driven by CRIO digital output module 606. This CRIO digital output module 606 is part of the break-out interface and controlled by the respective car unit real-time engine (not shown). In the closed switch state of the separation relay depicted in Fig. 8 the input 604 is connected to a first output 607 of the break-out box 602. The first output 607 is routed via the break-out terminal block 603 to the input 608 of the actuator 609 being a push button in this case. The output 610 of the actuator 609 is connected to another signal line 611 of the communication system 136 and to the break-out terminal block 603. The output 610 of the actuator 609 is routed via the break-out terminal block 603 to an input/output 612 of the break-out box 602.

The input/output 612 is connected to a second output 613 via a spy relay 614 that drives the CRIO digital input module 615. Via the spy relay 614 it is possible to spy on the actuation state of the actuator 609. The CRIO input module 615 is connected to the car unit real-time engine (not shown) of the respective car unit. The car unit real-time engine controls all spying and manipulating in that car unit.

The second output 613 is connected to a reference voltage line 616 of the communication system 136 via break-out terminal block 603.

In the open switch state of the separation relay 605 the input 604 is connected to the input/output 612 via a manipulation relay 617 driven by the CRIO output module 606. Thus in the open switch state the car unit real-time engine can manipulate or simulate an activation of the actuator 609 via the manipulation relay 617. As the input/output 612 is connected to the output 610 of the actuator 609 this manipulation is transparent, i.e. undetectable for the real car systems influenced by an activation of the actuator 609. This signal is carried on said another signal line 611 of the communication system also connected to the output 610 of the actuator 609.

In the open switch position of the separation relay 605 a spying on the activation of the actuator (effected by the manipulation relay 617) can be performed in the same way as in the closed switch state of the separation relay 605. It should be noted that the signal and control lines connecting the CRIO modules 606, 615 with the car unit real-time engine (not shown) are not depicted.

### Reference numerals

- 1 to 8: pictograms representing car train components and systems
- 101: train test platform
- 102: platform component
- 111 to 118: car units
- 119: supervisor unit
- 121 to 128: instrumentation units
- 136: communication system
- 137: reflective memory system
- 192: memory
- 220: memory space
- 221 to 228: subspaces
- 221-cuw to 218-cuw: car unit write section
- 221-suw to 218-suw: supervisor unit write section
- 231 to 239: memory tables
- 241 to 249: local reflective memory system components
- 260: loop (ring)
- 261: optical cable
- 270 to 278: computer
- 280: touch screen
- 300: signal and control lines
- 321-n to 321-k: instrumentation racks (n, k are natural numbers)
- 331 to 338: break-out interfaces
- 341-i to 341-j: break-out boxes (i, j are natural numbers)
- 351 to 358: break-out terminal blocks
- 361 to 368: car unit real-time engine
- 369: central real-time engine
- 371 to 378: car system model engine
- 381 to 388: break-out bus interface
- 391: break-out computer interface
- 400: (actual) train components
- 401: train control and Management system (TCMS)
- 402: heating, ventilation, and air conditioning (HVAC)
- 403: brake system
- 404: pantograph
- 405: power supply
- 406: driver desk
- 407: door system
- 421, 422: signal lines (of actual train component not being the communication system)
- 451: Human machine interface (HMI)
- 452: configuration management database
- 453: test script engine
- 454: record database
- 455: simulator (global model)
- 456: human machine interface
- 457: train environment model engine
- 458: technical data
- 459: scripts
- 460: simulator
- 501: train component hardware
- 502: break-out box
- 503: terminal block
- 504: contactor
- 505: system component
- 506: original wire
- 507: contactor output
- 508: normally closed relay
- 509: system component input
- 510: reference voltage line
- 511: CRIO module
- 512: power supply
- 513: spy relay
- 514: another CRIO module
- 515: another power supply
- 601: signal line
- 602: break-out box
- 603: break-out terminal block
- 604: input (of break-out box)
- 605: separation relay
- 606: CRIO digital output module
- 607: first output (of the break-out box)
- 608: input (of the actuator)
- 609: (electromechanical) actuator
- 610: output (of the actuator)
- 611: another signal line
- 612: input/ouput (of break-out box)
- 613: second output (of break-out box)
- 614: spy relay
- 615: CRIO input module
- 616: reference voltage line
- 617: manipulation relay
- 701: system controller
- 701: physical system
- 703: simulation hardware

## Claims

1. Train test platform (101) for a railway train comprising multiple cars said test platform (101) comprising:
- a car unit (111 to 118) for each of the multiple cars representing a respective one of the multiple real train cars each,
- a train communication system (136) connecting the car units (111 to 118),
- a supervisor unit (119), and
- reflective memory system (137)
wherein the reflective memory system (137) comprises a reflective memory table (231 to 239) of the same memory space for each car unit (111 to 118) and the supervisor unit (119), wherein said memory tables (231 to 239) are kept synchronous by the reflective memory system (137), and
wherein each car unit (111 to 118) comprises
an instrumentation unit,
said instrumentation unit providing the break-out interfaces (331 to 338) between the train communication system (136) and all train components in the respective car,
wherein the instrumentation unit further comprises:
at least one car unit real-time engine (361 to 368);
wherein said at least one car unit real-time engine (361 to 368) is capable of reading from and writing to the respective reflective memory table (231 to 239) of said respective car unit (111 to 118) and; configured to monitor and/or to manipulate signals at these break-out interfaces (331 to 338) in real-time, wherein monitored signals are written to the reflective memory table (231 to 239) and manipulations are carried out according to data read from the reflective memory table (231 to 239); and
a simulation unit for each car train system not physically present in the respective car to simulate the electrical behavior of said non present car train system as to react on signals dedicated for said non present car train system and as to provide the respective signals supplied by respective real car train system simulated, wherein a car train system is a train system located in one car unit representing the actual car,
wherein said supervisor unit (119) comprises:
a central system real-time engine interacting with the respective reflective memory table (231 to 239) via reading of data for recording and/or monitoring and or processing monitored signal data and via writing data to the reflective memory table (231 to 239) for manipulating signals in car units (111 to 118) and/or steering and controlling the car train systems.

2. Train test platform (101) according to claim 1, **characterized in that** the communication system (136) comprises the actual bus-system or bus-systems as well as the actual wiring except for cable length deviations where appropriate.

3. Train test platform (101) according to claim 1 or 2, wherein each car unit (111 to 118) comprises the complete actual train control and management system (401) including interlocks.

4. Train test platform (101) according to any one of the claims 1 to 3, wherein test platform (101) comprises one or several actual instances of car train systems out of the group: actual door system (407), brake system (403), driver desk (406), Heating, Ventilation, Air Conditioning (HVAC) cabinet including a HVAC cab unit (402), a battery charger (405) including batteries.

5. Train test platform (101) according to any one of the claims 1 to 4, **characterized in that** the test platform (101) comprises one or several instances of the car train components to be tested that are made up of actual train components partially only, and wherein missing actual parts are physically simulated, wherein these train components made up partially of actual train components are selected out of the group comprising: a pantograph, a brake system.

6. Train test platform (101) according to any one of the claims 1 to 5, **characterized in that** the instrumentation units also comprise break-out interfaces (331 to 338) for connecting sub components of a car train system with its control and/or interface unit of said car system, wherein said break-out interfaces can be monitored or manipulated via the respective at least one car unit real-time engine (361 to 368).

7. Train test platform (101) according to any one of the claims 1 to 6, **characterized in that** the supervisor unit (119) comprises a simulation engine to simulate train wide behavior.

8. Train test platform (101) according to any one of the claims 1 to 7, **characterized in that** the supervisor unit (119) comprises a script engine to execute scripts to perform automated test sequences.

9. Train test platform (101) according to any one of the claims 1 to 8, **characterized in that** the supervisor unit (119) comprises a human machine interface capable of providing monitoring data of the multiple car test train in a human perceptible fashion and capable of accepting human inputs to manipulate test train systems.

10. Train test platform (101) according to any one of the claims 1 to 9, **characterized in that** the simulation unit comprises a real-time car system simulation engine.

11. Train test platform (101) according to any one of the claims 1 to 10, **characterized in that** the simulation unit comprises a simulator that is realized physically at least partly.

12. Test train platform (101) according to any one of the claims 1 to 11, **characterized in that** at least one car unit (111 to 118) comprises at least one actuator (609) to influence the behavior of at least one train component in an actual train, and wherein the break-out interface (331 to 338) of the respective car unit is configured to alternatively enable or disable a signal input of said at least one actuator (609), and wherein the break-out interface (331 to 338) is further configured to create an equivalent input signal under the control of the supervisor unit (119) as a modification, when the actuator (609) input is disabled.

13. Test train platform (101) according to any one of the claims 1 to 12, **characterized in that** a human machine interface of an actual train component is modified by a software component to enable manipulated inputs in the car unit's human machine interface by the supervisor unit (119).

14. Test train platform (101) according to any one of the claims 1 to 13, **characterized in that** the location, which the steering/controlling of certain operational functions can be executed from, can be switched from supervisor unit (119) to the operational means of a driver desk in one of the car units (111 to 118), wherein display functions indicating the status of real train components (400) or simulated systems can be displayed in parallel on the supervisor's human machine interface and on a driver desk's human machine interface.

15. Use of a test platform (101) according to any one of the claims above for performing automated and/or manual integration testing of actual train components of a multiple-car train.

16. Method of testing actual car train components in an integrated multiple-car train environment comprising the steps of:
providing a test platform (101) according to any one of the claims 1 to 14, wherein the actual car train components to be tested are installed in the respective car units (111 to 118) of the test platform (101), such that at least some of the signals used for controlling the functionality of the actual car train components to be tested can be monitored and/or manipulated by the test platform (101) and/or at least some of the signals produced as feedback or as part of the functionality provided by said actual car train components to be tested, can be monitored,
power up the test platform (101) including the actual car train components to be tested; and
manipulate or simulate at least one signal of one of the actual car train components to be tested or of any one of the train components simulated by one of the car units (111 to 118) via the supervisor unit (119) by changing at least one memory entry in the reflective memory space.

17. Method according to claim 16, **characterized in that** the manipulation is carried out via executing a script on hardware of the supervisor unit (119).

18. Method according to claim 16 or 17, **characterized in that** at least all signals monitored are recorded in real-time in the supervisor unit (119).

## Patentansprüche

1. Zugtestplattform (101) für einen Zug, umfassend mehrere Wagen, wobei die Testplattform (101) umfasst:
- eine Wageneinheit (111-118) für jeden der mehreren Wagen, welche jeweils einen entsprechenden der Mehrzahl echter Zugwagen repräsentieren,
- ein Zugkommunikationssystem (136), welches die Wageneinheiten (111-118) verbindet,
- eine Leitstandeinheit (119) und ein Reflective-Memory-System (137),
wobei Reflective-Memory-System (137) Reflective-Memory-Tabellen (231-239) desselben Speicherraums für jede der Wageneinheiten (111-118) und die Leitstandeinheit (119) umfasst, wobei die Memory-Tabellen (231-239) mittels des Reflective-Memory-Systems (137) synchron gehalten werden und
wobei jede Wageneinheit (111-118) umfasst
- eine Instrumentationseinheit,
- wobei die Instrumentationseinheit Auskoppelschnittstellen (331-338) zwischen dem Zugkommunikationssystem (136) und allen Zugkomponenten in dem entsprechenden Wagen liefert, wobei die Instrumentationseinheit ferner umfasst:
mindestens eine Wageneinheit-Echtzeitmaschine (361-368);
- wobei die mindestens eine Wageneinheit-Echtzeitmaschine (361-368) in der Lage ist, aus der entsprechenden Reflective-Memory-Tabelle (231-239) der entsprechenden Wageneinheit (111-118) zu lesen und in diese zu schreiben; und ausgebildet ist, Signale an den Auskoppelschnittstellen (331-338) in Echtzeit zu überwachen und/oder zu manipulieren,
wobei die überwachten Signale in die Reflective-Memory-Tabelle (231-239) geschrieben werden und Manipulationen gemäß den Daten ausgeführt werden, die aus der Reflective-Memory-Tabelle (231-239) ausgelesen sind; und
eine Simulationseinheit für jedes Wagenzugsystem, welches physisch nicht in dem entsprechenden Wagen vorhanden ist, um das elektrische Verhalten des nicht vorhandenen Wagenzugsystems zu simulieren, um so auf Signale zu reagieren, die für das nicht vorhandene Wagenzugsystem bestimmt sind, und um entsprechende Signale bereitzustellen, die von dem entsprechenden echten Wagenzugsystem bereitgestellt werden, welches simuliert ist,
wobei das Wagenzugsystem ein Zugsystem ist, das in einer Wageneinheit angeordnet ist, die einen tatsächlichen Wagen repräsentiert;
wobei die Leitstandeinheit (119) umfasst: eine Zentralsystem-Echtzeitmaschine zum Interagieren mit der entsprechenden Reflective-Memory-Tabelle (231-239) über ein Lesen von Daten zum Aufzeichnen und/oder Überwachen und/oder Verarbeiten überwachter Signaldaten und für ein Manipulieren von Signalen in den Wageneinheiten (111-118) und/oder Steuern und/oder Regeln der Wagenzugsysteme über ein Schreiben von Daten in die Reflective-Memory-Tabelle (231-239).

2. Zugtestplattform (101) nach Anspruch 1, **dadurch gekennzeichnet, dass** das Kommunikationssystem (139) ein reales Bussystem oder Bussysteme als auch eine reale Verkabelung mit Ausnahme von Kabellängenabweichungen, wo dies angemessen ist, umfasst.

3. Zugtestplattform (101) nach Anspruch 1 oder 2, **dadurch gekennzeichnet, dass** jede Wageneinheit (111-118) ein vollständiges reales Zugsteuer- und Managementsystem (401) einschließlich Verriegelungen umfasst.

4. Zugtestplattform (101) nach einem der vorangegangenen Ansprüche 1 bis 3, wobei die Testplattform (101) ein oder mehrere reale Instanzen von Wagenzugsystemen aus der Gruppe umfasst: reales Türsystem (407), Bremssystem (403), Fahrstand (406), einen Heizungs-, Lüftungs- und Klimaanlagen (HVAC)-Schrank einschließlich einer Heizungs-, Lüftungs- und Klimaanlagenführerhauseinheit (402), eine Batterieladeeinrichtung (405) einschließlich Batterien.

5. Zugtestplattform (101) nach irgendeinem der vorangegangenen Ansprüche 1 bis 4, **dadurch gekennzeichnet, dass** die Testplattform (101) eine oder mehrere Instanzen von Wagenzugkomponenten umfasst, die zu testen sind, die nur teilweise aus realen Zugkomponenten ausgebildet sind, und wobei fehlende reale Teile physisch simuliert werden, wobei diese Zugkomponenten teilweise aus realen Zugkomponenten gebildet sind, die aus einer Gruppe ausgewählt sind, die umfasst:
einen Pantographen, ein Bremssystem.

6. Zugtestplattform (101) nach irgendeinem der vorangegangenen Ansprüche 1 bis 5, **dadurch gekennzeichnet, dass** die Instrumentationseinheiten ebenfalls Auskoppelschnittstellen (331-338) zum Verbinden von Unterkomponenten eines Wagenzugsystems mit den Regel- und Schnittstelleneinheiten des Wagensystems umfasst, wobei die Auskoppelschnittstellen über die entsprechende mindestens eine Wageneinheit-Echtzeitmaschine (361-368) überwacht oder manipuliert werden können.

7. Zugtestplattform (101) nach irgendeinem der Ansprüche 1 bis 6, **dadurch gekennzeichnet, dass** die Leitstandeinheit (119) eine Simulationsmaschine zum Simulieren eines zugweiten Verhaltens umfasst.

8. Zugtestplattform (101) nach irgendeinem der Ansprüche 1 bis 7, **dadurch gekennzeichnet, dass** die Leitstandeinheit (119) eine Skriptmaschine umfasst, zum Ausführen von Sripten, um automatisierte Testsequenzen auszuführen.

9. Zugtestplattform (101) gemäß irgendeinem der Ansprüche 1 bis 8, **dadurch gekennzeichnet, dass** die Leitstandeinheit (119) eine Mensch-Maschine-Schnittstelle umfasst, die in der Lage ist, Überwachungsdaten für den Mehrwagentestzug in einer menschlich wahrnehmbaren Weise zu liefern, und in der Lage ist, menschliche Eingaben zu erfassen, um Testzugsysteme zu manipulieren.

10. Zugtestplattform (101) gemäß irgendeinem der Ansprüche 1 bis 9, **dadurch gekennzeichnet, dass** die Simulationseinheit eine Echtzeit-Wagensystem-Simulationsmaschine umfasst.

11. Zugtestplattform (101) gemäß irgendeinem der Ansprüche 1 bis 10, **dadurch gekennzeichnet, dass** die Simulationseinheit einen Simulator umfasst, der zumindest teilweise physisch realisiert ist.

12. Zugtestplattform (101) gemäß irgendeinem der Ansprüche 1 bis 11, **dadurch gekennzeichnet, dass** zumindest eine Wageneinheit (111-118) mindestens einen Aktor (609) zum Beeinflussen des Verhaltens von mindestens einer Zugkomponente in einem realen Zug umfasst, und wobei die Auskoppelschnittstelle (331-338) der entsprechenden Wageneinheit konfiguriert ist, um alternativ eine Signaleingabe des mindestens einen Aktors (609) freizugeben oder zu sperren, und wobei die Auskoppelschnittstelle (331-338) ferner konfiguriert ist, um ein äquivalentes Eingabesignal unter der Steuerung der Leitstandeinheit (119) als eine Veränderung zu erzeugen, wenn die Eingabe des Aktors (609) gesperrt ist.

13. Zugtestplattform (101) nach irgendeinem der Ansprüche 1 bis 12, **dadurch gekennzeichnet, dass** die Mensch-Maschine-Schnittstelle einer realen Zugkomponente mittels einer Softwarekomponente verändert wird, um Manipulationseingaben in der Mensch-Maschine-Schnittstelle der Zugeinheit mittels der Leitstandeinheit freizugeben.

14. Zugtestplattform (101) nach irgendeinem der Ansprüche 1 bis 13, **dadurch gekennzeichnet, dass** der Ort, von dem aus die Steuerung und Regelung von bestimmten Betriebsfunktionen ausgeführt werden kann, von Leitstandeinheit (119) zu den Betriebsmitteln eines Fahrstands in einer der Wageneinheiten (111-118) geschaltet werden kann, wobei Anzeigefunktionen, die den Zustand realer Zugkomponenten (400) oder simulierter Systeme angeben, parallel auf der Mensch-Maschine-Schnittstelle des Leitstands und auf einer Mensch-Maschine-Schnittstelle eines Fahrerstands parallel angezeigt werden können.

15. Verwendung der Testplattform (101) gemäß irgendeinem der vorangehenden Ansprüche zum Ausführen von automatisierten und/oder manuellen integrierten Tests von realen Zugkomponenten eines Mehrwagenzugs.

16. Verfahren zum Testen realer Zugkomponenten in einer integrierten Mehrwagenzugumgebung, umfassen die Schritte:
Bereitstellen einer Testplattform gemäß irgendeinem der Ansprüche 1 bis 14, wobei die realen Zugkomponenten, die zu testen sind, in entsprechenden Wageneinheiten (111-118) der Testplattform (101) installiert sind, sodass zumindest einige der Signale, die zum Steuern der Funktionalität der realen Wagenzugkomponenten, die getestet werden sollen, verwendet werden, mittels der Testplattform überwacht und/oder manipuliert werden können und/oder mindestens einige der Signale, die als Rückkopplung oder als Teil der von den realen Zugkomponenten, die zu testen sind, gelieferten Signale erzeugt werden, überwacht werden können;
Einschalten der Testplattform einschließlich der realen Wagenzugkomponenten, die zu testen sind, Manipulieren oder Simulieren mindestens eines Signals von einer der realen Wagenzugkomponenten, die zu testen sind, oder von irgendeiner der Zugkomponenten, die mittels einer der Zugeinheiten (111-118) über die Leitstandeinheit (119) simuliert werden, indem mindestens ein Speichereintrag in den Reflective-Memory-Raum geändert wird.

17. Verfahren nach Anspruch 16, **dadurch gekennzeichnet, dass** die Manipulation über ein Ausführen eines Skripts auf einer Hardware der Leitstandeinheit (119) ausgeführt wird.

18. Verfahren nach Anspruch 16 oder 17, **dadurch gekennzeichnet, dass** zumindest alle überwachten Signale in Echtzeit in der Leitstandeinheit (119) aufgezeichnet werden.

## Revendications

1. Plateforme de test de train (101) pour un train de chemin de fer comprenant de multiples véhicules ferroviaires, ladite plateforme de test (101) comprenant :
- une unité de véhicule ferroviaire (111 à 118) pour chacun des multiples véhicules ferroviaires représentant chacune un respectif parmi les multiples véhicules ferroviaires de train réels,
- un système de communication de train (136) connectant les unités de véhicule ferroviaire (111 à 118),
- une unité de superviseur (119), et
- un système de mémoire réflexive (137)
dans lequel le système de mémoire réflexive (137) comprend une table de mémoire réflexive (231 à 239) du même espace de mémoire pour chaque unité de véhicule ferroviaire (111 à 118) et l'unité de superviseur (119), dans lequel lesdites tables de mémoire (231 à 239) sont maintenues synchrones par le système de mémoire réflexive (137), et dans lequel chaque unité de véhicule ferroviaire (111 à 118) comprend
une unité d'instrumentation,
ladite unité d'instrumentation fournissant les interfaces de test (331 à 338) entre le système de communication de train (136) et tous les composants de train dans le véhicule ferroviaire respectif,
dans lequel l'unité d'instrumentation comprend en outre :
au moins un moteur en temps réel d'unité de véhicule ferroviaire (361 à 368) ;
dans lequel ledit au moins un moteur en temps réel d'unité de véhicule ferroviaire (361 à 368) est capable de lire à partir de et d'écrire sur la table de mémoire réflexive respective (231 à 239) de ladite unité de véhicule ferroviaire respective (111 à 118) et ;
configuré pour surveiller et/ou pour manipuler des signaux à ces interfaces de test (331 à 338) en temps réel, dans lequel des signaux surveillés sont écrits dans la table de mémoire réflexive (231 à 239) et des manipulations sont réalisées selon des données lues à partir de la table de mémoire réflexive (231 à 239) ; et une unité de simulation pour chaque système de train de véhicule ferroviaire non physiquement présent dans le véhicule ferroviaire respectif pour simuler le comportement électrique dudit système de train de véhicule ferroviaire non présent afin de réagir à des signaux dédiés pour ledit système de train de véhicule ferroviaire non présent et afin de fournir les signaux respectifs fournis par le système de train de véhicule ferroviaire réel respectif simulé, dans lequel un système de train de véhicule ferroviaire est un système de train situé dans une unité de véhicule ferroviaire représentant le véhicule ferroviaire réel,
dans lequel ladite unité de superviseur (119) comprend un moteur en temps réel de système central interagissant avec la table de mémoire réflexive respective (231 à 239) par l'intermédiaire de la lecture de données pour enregistrer et/ou surveiller et/ou traiter des données de signal surveillé et par l'intermédiaire de l'écriture de données dans la table de mémoire réflexive (231 à 239) pour manipuler des signaux dans des unités de véhicule ferroviaire (111 à 118) et/ou orienter et commander les systèmes de train de véhicule ferroviaire.

2. Plateforme de test de train (101) selon la revendication 1, **caractérisé en ce que** le système de communication (136) comprend le système de bus ou les systèmes de bus réels ainsi que le câblage réel à l'exception de déviations de longueur de câble le cas échéant.

3. Plateforme de test de train (101) selon la revendication 1 ou 2, dans lequel chaque unité de véhicule ferroviaire (111 à 118) comprend le système de commande et de gestion de train réel complet (401) y compris des enclenchements.

4. Plateforme de test de train (101) selon l'une quelconque des revendications 1 à 3, dans lequel la plateforme de test (101) comprend un ou plusieurs exemples réels de systèmes de train de véhicule ferroviaire parmi le groupe : système de porte (407), système de frein (403), poste conducteur (406), armoire de chauffage, de ventilation et de climatisation (HVAC), y compris une unité d'armoire HVAC (402), un chargeur de batterie (405), y compris des batteries, réels.

5. Plateforme de test de train (101) selon l'une quelconque des revendications 1 à 4, **caractérisé en ce que** la plateforme de test (101) comprend un ou plusieurs exemples des composants de train de véhicule ferroviaire destinés à être testés qui sont composés de composants de train réels partiellement seulement, et dans lequel des parties réelles manquantes sont physiquement simulées, dans lequel ces composants de train composés partiellement de composants de train réels sont sélectionnés parmi le groupe comprenant : un pantographe, un système de frein.

6. Plateforme de test de train (101) selon l'une quelconque des revendications 1 à 5, **caractérisé en ce que** les unités d'instrumentation comprennent également des interfaces de test (331 à 338) pour connecter des sous-composants d'un système de train de véhicule ferroviaire avec son unité de commande et/ou d'interface dudit système de véhicule ferroviaire, dans lequel lesdites interfaces de test peuvent être surveillées ou manipulées par l'intermédiaire de l'au moins un moteur en temps réelle d'unité de véhicule ferroviaire respectif (361 à 368).

7. Plateforme de test de train (101) selon l'une quelconque des revendications 1 à 6, **caractérisé en ce que** l'unité de superviseur (119) comprend un moteur de simulation pour simuler un comportement dans la totalité du train.

8. Plateforme de test de train (101) selon l'une quelconque des revendications 1 à 7, **caractérisé en ce que** l'unité de superviseur (119) comprend un moteur de script pour exécuter des scripts pour réaliser des séquences de test automatisées.

9. Plateforme de test de train (101) selon l'une quelconque des revendications 1 à 8, **caractérisé en ce que** l'unité de superviseur (119) comprend une interface homme-machine capable de fournir des données de surveillance du train de test à véhicules ferroviaires multiples de façon humainement intelligible et capable d'accepter des entrées humaines pour manipuler des systèmes de train de test.

10. Plateforme de test de train (101) selon l'une quelconque des revendications 1 à 9, **caractérisé en ce que** l'unité de simulation comprend un moteur en temps réel de simulation de système de véhicule ferroviaire.

11. Plateforme de test de train (101) selon l'une quelconque des revendications 1 à 10, **caractérisé en ce que** l'unité de simulation comprend un simulateur qui est réalisé physiquement au moins partiellement.

12. Plateforme de test de train (101) selon l'une quelconque des revendications 1 à 11, **caractérisé en ce qu'**au moins une unité de véhicule ferroviaire (111 à 118) comprend au moins un actionneur (609) pour influencer le comportement d'au moins un composant de train dans un train réel, et dans lequel l'interface de test (331 à 338) de l'unité de véhicule ferroviaire respective est configurée pour activer ou désactiver en alternance une entrée de signal dudit au moins un actionneur (609), et dans lequel l'interface de test (331 à 338) est en outre configurée pour créer un signal d'entrée équivalent sous le contrôle de l'unité de superviseur (119) en tant que modification, lorsque l'entrée de l'actionneur (609) est désactivée.

13. Plateforme de test de train (101) selon l'une quelconque des revendications 1 à 12, **caractérisé en ce qu'**une interface homme-machine d'un composant de train réel est modifiée par un composant logiciel pour permettre des entrées manipulées dans l'interface homme-machine de l'unité de véhicule ferroviaire par l'unité de superviseur (119).

14. Plateforme de test de train (101) selon l'une quelconque des revendications 1 à 13, **caractérisé en ce que** l'emplacement, d'où l'orientation/la commande de certaines fonctions opérationnelles peut être exécutée, peut être commuté de l'unité de superviseur (119) aux moyens opérationnels d'un poste de conducteur dans une des unités de véhicule ferroviaire (111 à 118), dans lequel des fonctions d'affichage indiquant l'état des composants de train réels (400) ou de systèmes simulés peuvent être affichées en parallèle sur l'interface homme-machine du superviseur et sur une interface homme-machine du poste de conducteur.

15. Utilisation d'une plateforme de test (101) selon l'une quelconque des revendications précédentes pour réaliser des tests d'intégration automatisés et/ou manuels de composants de train réels d'un train à multiples véhicules ferroviaires.

16. Procédé de tests de composants de train de véhicule ferroviaire réels dans un environnement intégré de train à multiples véhicules ferroviaires, comprenant les étapes de :
la fourniture d'une plateforme de test (101) selon l'une quelconque des revendications 1 à 14, dans lequel les composants de train de véhicule ferroviaire réels destinés à être testés sont installés dans les unités de véhicule ferroviaire respectives (111 à 118) de la plateforme de test (101), de telle sorte qu'au moins certains des signaux utilisés pour commander la fonctionnalité des composants de train de véhicule ferroviaire réels destinés à être testés puissent être surveillés et/ou manipulés par la plateforme de test (101) et/ou au moins certains des signaux produits sous forme de rétroaction ou en tant que partie de la fonctionnalité fournie par lesdits composants de train de véhicule ferroviaire réels destinés à être testés, puissent être surveillés,
l'allumage de la plateforme de test (101) y compris des composants de train de véhicule ferroviaire réels destinés à être testés ; et
la manipulation ou simulation d'au moins un signal d'un des composants de train de véhicule ferroviaire réels destinés à être testés ou d'un quelconque des composants de train simulés par une des unités de véhicule ferroviaire (111 à 118) par l'intermédiaire de l'unité de superviseur (119) en changeant au moins une entrée de mémoire dans l'espace de mémoire réflective.

17. Procédé selon la revendication 16, **caractérisé en ce que** la manipulation est réalisée par l'intermédiaire de l'exécution d'un script sur le matériel de l'unité de superviseur (119).

18. Procédé selon la revendication 16 ou 17, **caractérisé en ce qu'**au moins tous les signaux surveillés sont enregistrés en temps réel dans l'unité de superviseur (119).
